# FASCICULE DE BREVET EUROPEEN

(11) **EP 1 549 123 B1**
(45) Date de publication et mention de la délivrance du brevet: **31.12.2008**
(21) Numéro de dépôt: 04292860.6
(22) Date de dépôt: 02.12.2004
(51) Int. Cl.: H05K 7/20

(54) **Système de ventilation pour un appareillage électrique ou électronique**
Lüftungssystem für elektrische oder elektronische Geräte
Ventilation system for electrical or electronic devices

(30) Priorité: 23.12.2003 FR 0315315
(43) Date de publication de la demande: 29.06.2005
(73) Titulaire: SAGEM Défense Sécurité, 75015 Paris (FR)
(72) Inventeur: Merlet, Etienne, 78180 Montigny le Bretonneux (FR); Besold, Jean-Eric, 91400 Saclay (FR)
(74) Mandataire: Bérogin, Francis

(56) Documents cités:
- EP-A- 0 588 414
- US-A- 5 890 959
- US-A- 6 042 348
- US-A- 6 104 003

## Description

L'invention a trait au refroidissement des appareillages électriques ou électroniques.

Plus précisément, l'invention concerne un système de ventilation pour un appareillage électrique ou électronique installé dans une enceinte d'un boîtier dans lequel on souhaite créer un mouvement puis une extraction d'air destiné à refroidir l'appareillage en fonctionnement.

Les problèmes liés à ce type d'appareil se sont posés aux inventeurs dans le domaine de l'aéronautique. En effet, dans les aéronefs, où les contraintes mécaniques, mais surtout thermiques sont importantes, il est indispensable de s'assurer de la fiabilité du système de ventilation des appareillages électriques ou électroniques, afin qu'en toute circonstance le refroidissement de l'appareillage soit assuré. Lorsque l'appareillage est constitué de circuits électroniques de commande du pilotage automatique (ou de tout autre système vital), on comprend aisément qu'un défaut de ventilation, qui entraînerait immanquablement un échauffement des circuits, pourrait avoir des conséquences désastreuses sur la sécurité de l'aéronef.

On connaît de la demande de brevet européen publiée sous le numéro EP-0-588414 un système de refroidissement par air forcé pour un appareillage électronique, qui comprend :
- une enceinte entourant des composants de l'appareillage électronique, cette enceinte définissant un chemin pour l'écoulement de l'air de refroidissement,
- un premier souffleur monté dans le chemin d'écoulement d'air de manière que pratiquement la totalité de cet écoulement passe par le premier souffleur,
- un deuxième souffleur également monté dans le chemin d'écoulement de manière que pratiquement la totalité de cet écoulement d'air passe par le deuxième souffleur,
- un moyen de détection de pannes, et
- un moyen de commutation réagissant au moyen de détection de pannes pour assurer la commutation de l'un des souffleurs depuis un mode hors service à un mode en service, de manière à compenser l'effet de la panne.

Ce type de système donne satisfaction en ce sens qu'il permet de prendre en compte une panne et d'assurer, malgré celle-ci, le refroidissement de l'appareillage électronique. Toutefois, lorsqu'une panne se produit, le souffleur touché par la panne constitue alors un obstacle à la circulation de l'air, puisque, comme cela est rappelé ci-dessus, il embrasse pratiquement la totalité de l'écoulement d'air.

L'invention vise à remédier notamment aux inconvénients précités en proposant un système de ventilation qui permette d'assurer un refroidissement à la fois efficace et uniforme d'un appareillage électrique ou électronique, et ce même lorsqu'une panne vient affecter jusqu'à 50 % des capacités du système de ventilation.

A cet effet, l'invention propose, suivant un premier aspect, un système, connu par US-A-6,104,003, de ventilation d'un appareillage électrique ou électronique installé dans une enceinte d'un boîtier ayant une entrée d'air et une sortie d'air pour créer un écoulement d'air dans ladite enceinte, qui comporte au moins deux sources d'aspiration d'air, à savoir une source primaire et une source secondaire, ainsi qu'un caisson destiné à être monté sur ledit boîtier du côté de la sortie d'air, et qui se **caractérise en ce que** ce caisson définit au moins deux cavités cloisonnées, destinées à être raccordées toutes deux à la sortie d'air, à savoir une cavité primaire, raccordée à la source primaire, et une cavité secondaire, raccordée à la source secondaire.

De la sorte, on crée deux circuits séparés d'évacuation de l'air à la sortie de l'enceinte. Lorsque les deux sources d'aspiration sont opérationnelles, c'est-à-dire lorsque le système de ventilation peut fonctionner à pleine capacité, l'air est aspiré conjointement par les deux sources. Les circuits d'évacuation d'air étant séparés grâce au cloisonnement des cavités, il n'y a pas de risque de transfert de charge d'un circuit vers l'autre. Il en résulte un fonctionnement autonome de chacune des sources d'aspiration, au bénéfice de la fiabilité du système de ventilation.

Par ailleurs, lorsque l'une des sources d'aspiration tombe en panne, entraînant une perte de 50 % des capacités opérationnelles du système de ventilation, il n'y a pas de risque que la source encore opérationnelle entraîne l'apparition d'un courant d'air inverse provenant de la source en panne, puisque, les cavités étant cloisonnées-c'est-à-dire isolées l'une de l'autre-, les circuits d'évacuation d'air sont séparés.

Suivant un premier mode de réalisation, le caisson définit deux cavités imbriquées, séparées par une cloison continue.

Dans ce cas, les cavités sont de préférence symétriques ; elles présentent par exemple une symétrie centrale.

Par exemple, la cloison s'étend suivant un motif crénelé, chaque cavité ayant la forme d'un peigne.

Suivant un deuxième mode de réalisation, le caisson comporte une pluralité de cavités primaires et une pluralité de cavités secondaires alternées, les cavités primaires étant raccordées à la source primaire et les cavités secondaires à la source secondaire.

Dans ce cas, les cavités sont séparées par une pluralité de cloisons parallèles qui isolent les cavités primaires des cavités secondaires.

Suivant un mode préféré de réalisation, le caisson définit une chambre primaire par l'intermédiaire de laquelle la ou chaque cavité primaire est raccordée fluidiquement à la source primaire, et une chambre secondaire par l'intermédiaire de laquelle la ou chaque cavité secondaire est raccordée fluidiquement à la source secondaire.

En outre, le caisson comporte de préférence une paroi séparant chaque cavité de la chambre correspondante, ladite paroi étant munie d'au moins une ouverture primaire par laquelle la cavité primaire communique avec la chambre primaire, et d'au moins une ouverture secondaire par laquelle la cavité secondaire communique avec la chambre secondaire.

Chaque source d'aspiration est par exemple un ventilateur, monté sur le caisson.

En variante, chaque source d'aspiration comporte une turbine.

Suivant un second aspect, l'invention propose un appareil de refroidissement d'un appareillage électrique ou électronique, qui comporte un boîtier définissant une enceinte destinée à recevoir ledit appareillage, ce boîtier ayant une entrée d'air et une sortie d'air pour créer un écoulement d'air dans ladite enceinte, ainsi qu'un système de ventilation selon le premier aspect de l'invention tel que défini ci-dessus.

La sortie d'air du boîtier est par exemple formée par une paroi supérieur perforée.

De préférence, les cavités couvrent conjointement toute la surface de la sortie d'air, de manière à maximiser le débit de l'air évacué par les sources d'aspiration.

D'autres objets et avantages de l'invention apparaîtront à la lumière de la description faite ci-après en référence aux dessins annexés dans lesquels :
- la figure 1 est une vue de dessus en perspective éclatée montrant un appareil de refroidissement d'un appareillage électrique ou électronique ;
- la figure 2 est une vue de dessus en perspective éclatée d'un détail de la figure 1, montrant le système de ventilation de l'appareil de la figure 1, suivant un premier mode de réalisation ;
- la figure 3 est une vue en perspective de dessous du système de ventilation de la figure 2, représenté assemblé ;
- la figure 4 est une vue en plan de dessus du caisson du système de ventilation des figures 2 et 3 ;
- la figure 5 est une vue en plan de dessous du caisson de la figure 4 ;
- la figure 6 est une vue en plan de dessus, en arraché, du caisson suivant un second mode de réalisation ;
- la figure 7 est une vue en perspective de dessus, en arraché partiel, du caisson de la figure 6 ;
- la figure 8 est une vue en plan de dessous du caisson des figures 6 et 7, et
- la figure 9 est une vue en perspective de dessous du caisson des figures 6 à 8.

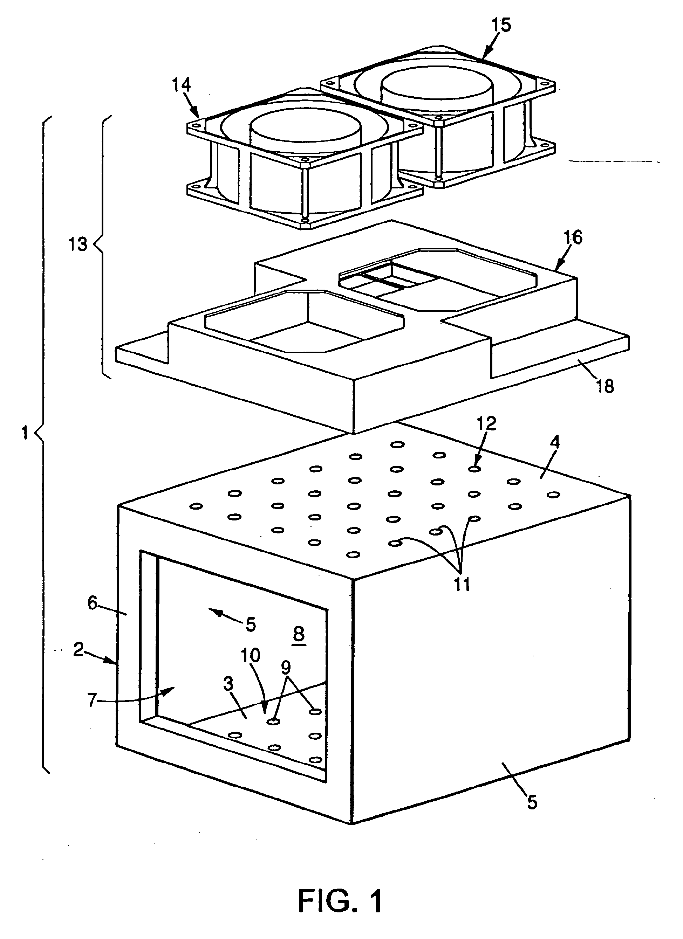

Sur la figure 1 est représenté un appareil 1 pour le refroidissement d'un appareillage électrique ou électronique. Cet appareil 1 comporte un boîtier 2 parallélépipédique, par exemple métallique, ou métallisé dans l'éventualité ou une protection électromagnétique devrait être assurée, boîtier 2 qui présente une paroi inférieure 3, par laquelle le boîtier 2 repose sur un support (non représenté), et une paroi supérieure 4 opposée, reliées par des parois latérales 5, 6 dont trois 5 sont borgnes et dont l'une, dite paroi avant 6, est munie d'une ouverture 7.

Les parois 5, 6 du boîtier 2 définissent conjointement une enceinte 8 dans laquelle est placé, après avoir été introduit par l'ouverture 7, l'appareillage électrique ou électronique, qui-peut être constitué par une pluralité de cartes portant des circuits intégrés, par exemple destinés à assurer la commande de pilotage automatique d'un aéronef.

Comme cela est visible sur la figure 1, la paroi inférieure 3 du boîtier 2 est munie d'une pluralité de perforations 9 qui mettent en communication l'enceinte 8 avec l'air ambiant pour former une entrée d'air 10. De même, la paroi supérieure 4 est munie d'une pluralité de perforations 11 qui, à l'opposé de la paroi inférieure 3, forment une sortie d'air 12 pour créer, conjointement avec l'entrée d'air 10, un écoulement d'air dans l'enceinte 8, destiné à refroidir l'appareillage électrique ou électronique.

Le support sur lequel est posé le boîtier 2 peut être muni d'une ventilation intégrée raccordée à l'alimentation électrique du local dans lequel est disposé l'appareil 1, en l'occurrence l'alimentation électrique générale de l'aéronef. Lorsqu'une telle ventilation existe, elle peut être sujette aux pannes. Aussi est-il proposé d'équiper l'appareil 1 d'un système d'extraction d'air 13 destiné à assurer une ventilation forcée de l'enceinte 8.

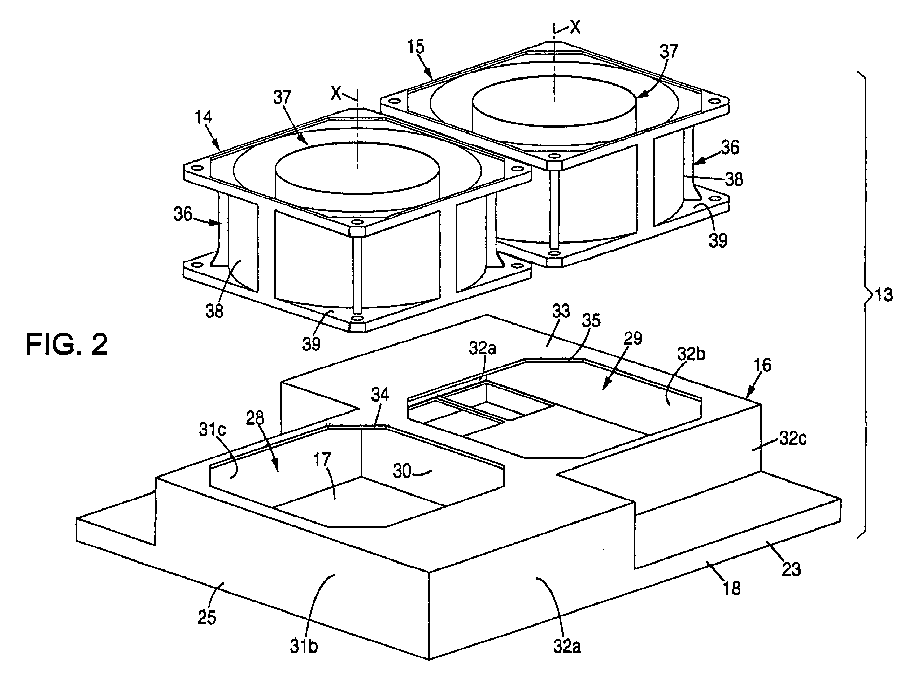

Ce système d'extraction d'air 13 comporte au moins deux sources s'aspiration d'air, en l'occurrence formées respectivement par deux ventilateurs 14, 15 (deux exactement dans l'exemple illustré sur les figures 1 et 2), à savoir un ventilateur primaire 14 et un ventilateur secondaire 15, montés sur un caisson 16 fixé à son tour sur le boîtier 2 du côté de la paroi supérieure 4 dont il recouvre la sortie d'air 12.

Ce caisson 16 est conçu pour générer deux circuits séparés d'évacuation de l'air à la sortie de l'enceinte 8, à savoir un circuit primaire traversant le ventilateur primaire 14 et un circuit secondaire traversant le ventilateur secondaire 15. Nous verrons ci-après comment sont réalisés ces deux circuits.

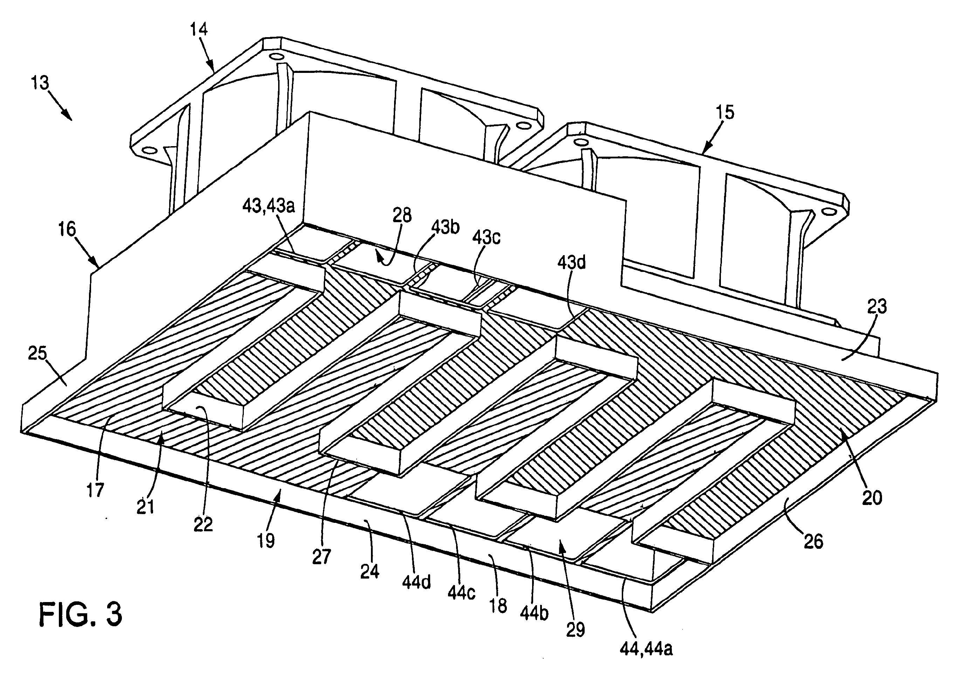

Comme cela est visible sur la figure 3, le caisson comporte une paroi de fond 17 sensiblement parallèle à la paroi supérieure 4 du boîtier 2, bordée par une jupe 18 qui s'étend en saillie vers le boîtier 2, et grâce à laquelle le caisson 16 peut s'emboîter sur le boîtier 2.

La paroi 17 et la jupe 18 définissent conjointement un volume 19 qui, lorsque le caisson 16 est fixé sur le boîtier 2, surplombe la sortie d'air 12.

Comme cela est visible notamment sur la figure 3, le volume 19 est divisé en au moins deux cavités 20, 21 séparées par une cloison 22 joignant deux bords opposés 23, 24 ou 25, 26 de la jupe 18, cette cloison 22 formant saillie par rapport à la paroi de fond 17. Cette cloison 22 présente une surface d'extrémité 27 tournée à l'opposé de la paroi 17 et qui, lorsque le caisson 16 est monté sur le boîtier 2, vient s'appliquer contre la paroi supérieure 4 de celui-ci.

Ainsi, lorsque le caisson 16 est monté sur le boîtier 2, la cloison 22 isole la cavité primaire 20 de la cavité secondaire 21, l'air ne pouvant circuler directement de l'une à l'autre.

Comme illustré sur la figure 2, le caisson 16 définit par ailleurs, du côté supérieur de la paroi 17 -c'est-à-dire du côté opposé aux cavités 20, 21-, deux chambres 28, 29, à savoir une chambre primaire 28 à laquelle est raccordé fluidiquement le ventilateur primaire- 14 et par laquelle transite l'air du circuit primaire, et une chambre secondaire 29 à laquelle est raccordé fluidiquement le ventilateur secondaire 15 et par laquelle est destiné à transiter l'air du circuit secondaire.

Comme les cavités 20, 21, les chambres 28, 29 sont isolées l'une de l'autre par une cloison de séparation 30 qui s'étend en saillie par rapport à la paroi 17, du côté supérieur de celle-ci.

Comme cela est visible sur la figure 2, les chambres 28, 29 sont bordées par des parois latérales 31a, 31b, 31c et 32a, 32b, 32c qui s'étendent en saillie du côté supérieur de la paroi de fond 17 et sont surmontées d'une paroi supérieure 33 dans laquelle sont pratiquées deux fenêtres 34, 35, à savoir une fenêtre primaire 34 donnant accès à la chambre primaire 28 et une fenêtre secondaire 35 donnant accès à la chambre secondaire 29.

Comme cela est illustré sur les figures 1 à 3, chaque ventilateur 14, 15 comporte un boîtier 36 dans lequel un rotor 37 est monté à rotation autour d'un axe X fixe par rapport au boîtier 36. Chaque boîtier 36 comporte une paroi latérale 38 essentiellement cylindrique qui s'étend parallèlement à l'axe X du rotor 37 et dont une extrémités inférieure 39 est conformée en platine par laquelle le boîtier 36 est fixé au caisson 16 (par exemple par vissage), en venant recouvrir la fenêtre 34, 35 correspondante.

Dans l'exemple représenté, les ventilateurs 14, 15 sont des ventilateurs axiaux (c'est-à-dire qu'ils-évacuent l'air parallèlement à leur axe X de rotation), mais il pourrait s'agir de turbines, évacuant l'air perpendiculairement à leur axe X.

Comme cela est représenté, notamment sur la figure 3, le caisson 16 est muni d'ouvertures 43, 44 pratiquées dans la paroi 17 pour mettre en communication fluidiques les cavités 20, 21 avec les chambres 28, 29, à savoir :
- au moins une ouverture primaire 43 pratiquée au droit de la cavité primaire 20, pour mettre celle-ci en communication fluidique avec la chambre primaire 28, et
- au moins une ouverture secondaire 44 pratiquée au droit de la cavité secondaire 21, pour mettre celle-ci en communication fluidique avec la chambre secondaire 29.

Ainsi, l'air du circuit primaire passe, à la sortie du boîtier 2, par la cavité primaire 20, transite par les ouvertures primaires 43, traverse la chambre primaire 28 avant d'être expulsé par le ventilateur primaire.

L'air du circuit secondaire passe quant à lui, à la sortie du boîtier 2, par la cavité secondaire 21, transite par les ouvertures secondaires 44, traverse la chambre secondaire 29 avant d'être expulsé par le ventilateur secondaire.

L'on décrit ci-après deux modes de réalisation du caisson 17, suivant le nombre et la forme des cavités 20, 21.

Suivant un premier mode de réalisation, décrit en référence aux figures 3 à 5, le caisson 17 comporte exactement deux cavités 20, 21 qui, ayant chacune la forme d'un peigne, sont imbriquées l'une dans l'autre en étant séparées par une cloison 22 continue s'étendant suivant un motif crénelé.

Si les cavités 20, 21 couvrent conjointement toute la surface de la sortie d'air 12, leur imbrication permet à chacune d'embrasser quasiment la totalité de cette surface.

De la sorte, lorsque l'un des circuits d'air, primaire ou secondaire, est inopérant par suite d'une panne affectant l'un des ventilateurs 14, 15, l'écoulement de l'air par le circuit opérationnel reste sensiblement uniforme sur la totalité de la sortie d'air 12.

En outre, compte tenu de la forme de chaque cavité 20, 21, la dépression provoquée par les ventilateurs 14, 15 génère dans l'enceinte 8 la formation de nappes d'air parallèles ascendantes qui viennent s'engouffrer dans les perforations 9 pour suivre ensuite les deux circuits séparés d'évacuation.

Lorsque l'un des ventilateurs -par exemple le ventilateur primaire 14- tombe en panne, le ventilateur secondaire 15 génère dans l'enceinte 8 des nappes d'air ascendantes qui entraînent par inertie l'apparition entre elles d'un mouvement d'air, également ascendant, qui s'engouffre, au travers des perforations 9, dans la cavité primaire 20 pour être évacué en suivant le circuit primaire, et ce malgré l'arrêt du ventilateur 14 correspondant. Et, comme les perforations 11 génèrent des pertes de charge, il n'y a pas de risque qu'apparaisse au sein de l'enceinte 8 une circulation en boucle de l'air.

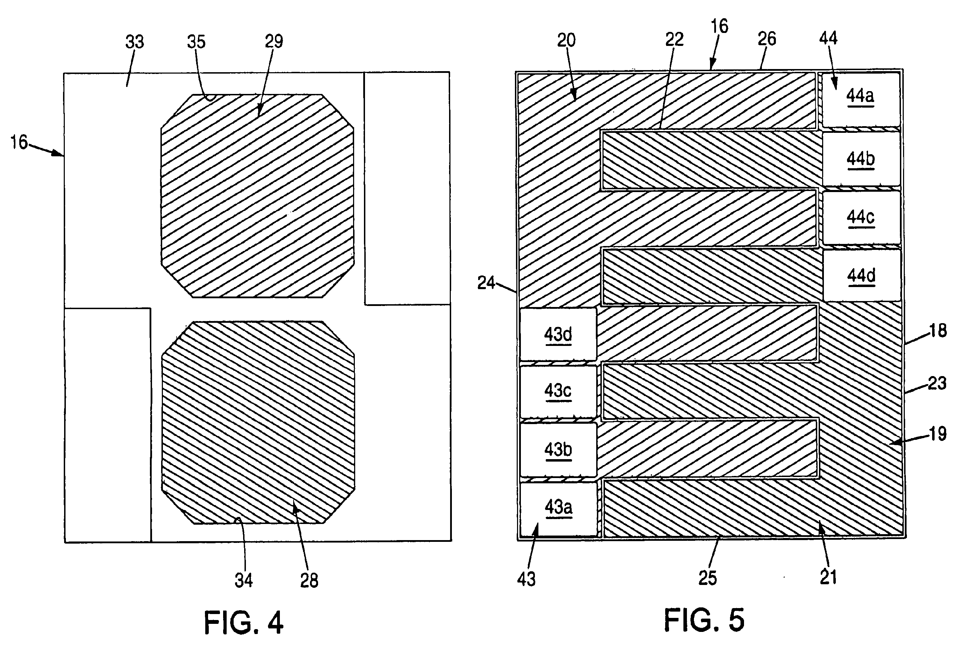

L'homme du métier veillera à ce que chaque circuit d'air présente un débit suffisant. A cet effet, on peut faire varier la section des ouvertures 43, 44. En l'occurrence, plusieurs ouvertures primaires 43 et secondaires 44 sont ménagées dans la paroi 17. Dans l'exemple illustré sur les figures 3 et 5, une rangée de quatre ouvertures primaires 43a, 43b, 43c, 43d est prévue dans la paroi 17 pour mettre en communication la cavité primaire 20 et la chambre primaire 28, et une rangée de quatre ouvertures secondaires 44a, 44b, 44c, 44d est prévue dans la paroi 17 pour mettre en communication la cavité secondaire 21 et la chambre secondaire 29.

Comme cela est visible sur la figure 5, les ouvertures primaires 43a, 43b, 43c, 43d et secondaires 44a, 44b, 44c, 44d sont respectivement regroupées dans deux coins diagonalement opposés de la paroi 17, mais on pourrait les répartir plus uniformément le long de celle-ci.

En outre, comme cela apparaît également sur la figure 5, les cavités 20, 21 sont symétriques l'une par rapport à l'autre. Plus précisément, elles présentent une symétrie centrale par rapport à un axe médian du caisson 16, perpendiculaire à la paroi 17.

De la sorte, d'une part, lorsque les deux ventilateurs 14, 15 sont opérationnels, l'écoulement de l'air dans l'enceinte 8 est sensiblement uniforme et, d'autre part, il est indifférent que, lorsque survient une panne, celle-ci affecte l'un ou l'autre des ventilateurs 14, 15.

En outre, la présence des perforations 11 sur la paroi supérieure 4 du boîtier 2 génère une perte de charge l'apparition d'un courant d'air en boucle dans le boîtier est empêchée par la perte de charge générée par les perforations en sortie d'air du boîtier

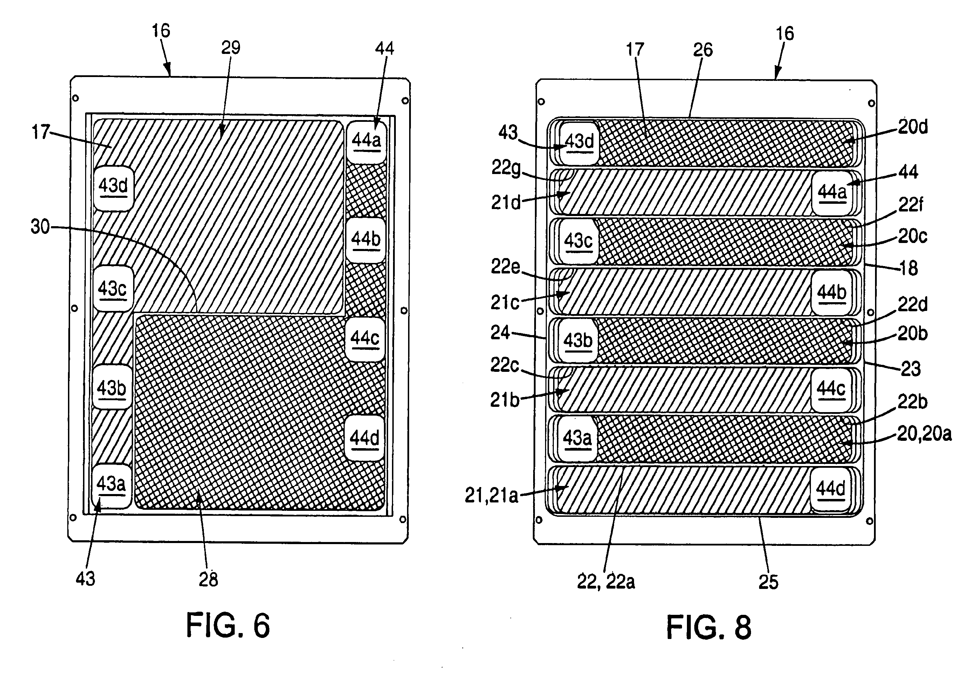

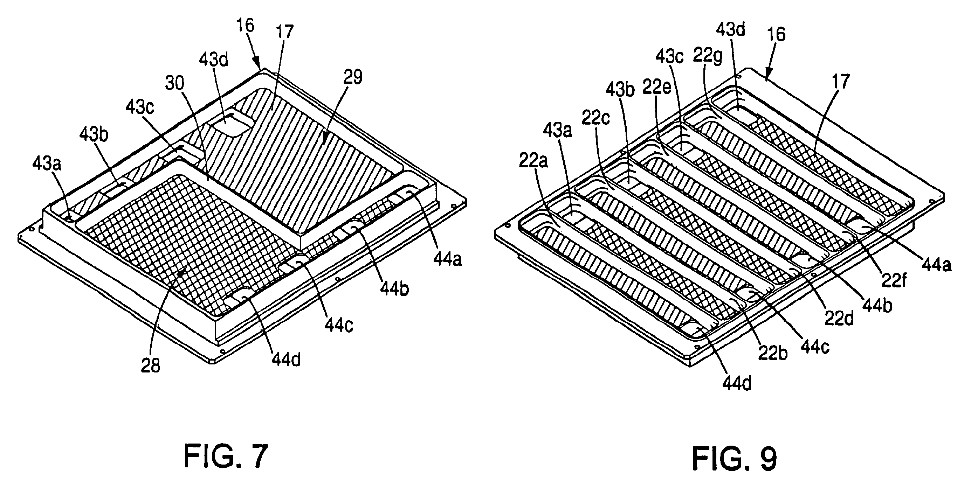

Suivant un deuxième mode de réalisation, illustré sur les figures 6 à 9, le caisson 16 comporte une pluralité de cavités primaires 20a, 20b, 20c, 20d et une pluralité de cavités secondaires 21a, 21b, 21c, 21d, alternées, séparées deux à deux par une pluralité de cloisons 22a à 22g parallèles -linéaire en l'occurrence- qui relient deux bords opposés 25, 26 de la jupe 18.

Une ouverture primaire 43a, 43b, 43c, 43d est pratiquée dans la paroi 17 au voisinage d'un bord 23, pour chaque cavité primaire 20a, 20b, 20c, 20d, tandis qu'une ouverture secondaire 44a, 44b, 44c, 44d est pratiquée au voisinage du bord opposé pour chaque ouverture secondaire 21a, 21b, 21c, 21d.

De la sorte, les cavités primaires 20a à 20d sont toutes mises en communication fluidique avec la chambre primaire 28, tandis que les cavités secondaires 21a à 21d sont toutes mises en communication fluidique avec la chambre secondaire 29.

Compte tenu de la symétrie et de l'uniformité de cette disposition, les avantages en terme d'écoulement de l'air sont les mêmes que mentionnés précédemment dans la description du premier mode de réalisation.

## Revendications

1. Système de ventilation (13) pour un appareillage électrique ou électronique installé dans une enceinte (8) d'un boîtier (2) ayant une entrée d'air (10) et une sortie d'air (12) pour créer un écoulement d'air dans ladite enceinte (8), ce système de ventilation (13) comportant au moins deux sources d'aspiration d'air (14, 15), à savoir une source primaire (14) et une source secondaire (15), ainsi qu'un caisson (16) destiné à être monté sur ledit boîtier (2) du côté de la sortie d'air (12), **caractérisé en ce que** ledit caisson (16) définit au moins deux cavités (20, 21) cloisonnées, destinées à être raccordées toutes deux à la sortie d'air (12), à savoir une cavité primaire (20), raccordée à la source primaire (14), et une cavité secondaire (21), raccordée au à la source secondaire (15).

2. Système de ventilation selon la revendication 1, dans lequel le caisson (16) définit deux cavités (20, 21) imbriquées, séparées par une cloison (22) continue.

3. Système de ventilation selon la revendication 2, dans lequel les cavités (20, 21) sont symétriques l'une par rapport à l'autre.

4. Système de ventilation selon la revendication 3, dans lequel les cavités (20, 21) présentent, l'une par rapport à l'autre, une symétrie centrale.

5. Système de ventilation selon l'une des revendications 2 à 4, dans lequel la cloison de séparation (22) s'étend suivant un motif crénelé, chaque cavité (20, 21) ayant la forme d'un peigne.

6. Système de ventilation selon la revendication 1, dans lequel le caisson (16) définit une pluralité de cavités primaire (20a à 20d) et une pluralité de cavités secondaires (21a à 21d) alternées, les cavités primaires (20a à 20d) étant raccordées à la source primaire (14) tandis que les cavités secondaires (21a à 21d) sont raccordées à la source secondaire (15).

7. Système de ventilation selon la revendication 6, dans lequel les cavités secondaires (21a à 21d) sont séparées des cavités primaires (20a à 20d) par une pluralité de cloisons (22a à 22g) parallèles.

8. Système de ventilation selon l'une des revendications 1 à 7, dans lequel le caisson (16) définit une chambre primaire (28) par l'intermédiaire de laquelle la ou chaque cavité primaire (20 ; 20a à 20d) est raccordée à la source primaire (14), et une chambre secondaire (29) par l'intermédiaire de laquelle la ou chaque cavité secondaire (21 ; 21a à 21D) est raccordée à la source secondaire (15).

9. Système de ventilation selon la revendication 8, dans lequel le caisson (16) comporte une paroi (17) qui sépare chaque cavité (20, 20a à 20d ; 21, 21a à 21d) de la chambre (28, 29) correspondante, ladite paroi (17) étant munie d'au moins une ouverture primaire (43 ; 43a à 43d) par laquelle la chambre primaire (28) communique avec la ou chaque cavité primaire (20 ; 20a à 20d), et d'au moins une ouverture secondaire (44 ; 44a à 44d) par laquelle la chambre secondaire (29) communique avec la ou chaque cavité secondaire (21 ; 21a à 21d).

10. Système de ventilation selon l'une des revendications 1 à 9, dans lequel chaque source d'aspiration d'air est un ventilateur (14, 15) monté sur ledit caisson (16).

11. Système de ventilation selon l'une des revendications 1 à 9, dans lequel chaque source d'aspiration d'air comporte une turbine.

12. Appareil (1) de refroidissement d'un appareillage électrique ou électronique, qui comporte un boîtier (2) définissant une enceinte (8) destinée à recevoir ledit appareillage, ce boîtier (2) ayant une entrée d'air (10) et une sortie d'air (12) pour créer un écoulement d'air dans ladite enceinte (8), ledit appareil étant **caractérisé en ce qu'**il comporte un système de ventilation (13) selon l'une quelconque des revendications 1 à 11.

13. Appareil selon la revendication 12, dans lequel la sortie d'air (12) du boîtier (2) est formée par une paroi supérieure (4) perforée.

14. Appareil selon la revendication 12 ou 13, dans lequel les cavités (20, 21) couvrent conjointement toute la surface de la sortie d'air (12).

## Claims

1. A ventilation system (13) for electrical or electronic equipment installed in an enclosure (8) of a box (2) having an air inlet (10) and an air outlet (12) for establishing a flow of air through said enclosure (8), the ventilation system (13) having at least two air suction sources (14, 15), namely a primary source (14) and a secondary source (15), and a chest (16) for being mounted on said box (2) beside the air outlet (12), **characterized in that** said chest (16) defines at least two separate cavities (20, 21), both for being connected to the air outlet (12), namely a primary cavity (20) connected to the primary source (14), and a secondary cavity (21) connected to the secondary source (15).

2. A ventilation system according to claim 1, in which the chest (16) defines two interleaved cavities (20, 21) separated from each other by a continuous partition (22).

3. A ventilation system according to claim 2, in which the cavities (20, 21) are symmetrical relative to each other.

4. A ventilation system according to claim 3, in which the cavities (20, 21) present central symmetry relative to each other.

5. A ventilation system according to any one of claims 2 to 4, in which the separating partition (22) extends in a crenellated pattern, each cavity (20, 21) being in the form of a comb.

6. A ventilation system according to claim 1, in which the chest (16) defines a plurality of primary cavities (20a - 20d) and a plurality of secondary cavities (21a - 21 d) in alternation, the primary cavities (20a - 20d) being connected to the primary source (14), while the secondary cavities (21a - 21 d) are connected to the secondary source (15).

7. A ventilation system according to claim 6, in which the secondary cavities (21a - 21 d) are separated from the primary cavities (20a - 20d) by a plurality of parallel partitions (22a - 22g).

8. A ventilation system according to any one of claims 1-7, in which the chest (16) defines a primary chamber (28) via which the or each primary cavity (20; 20a - 20d) is connected to the primary source (14), and a secondary chamber (29) via which the or each secondary cavity (21; 21a - 21 d) is connected to the secondary source (15).

9. A ventilation system according to claim 8, in which the chest (16) comprises a main wall (17) which separates each of the cavities (20, 20a - 20d; 21, 21a - 21 d) from the corresponding chamber (28, 29), said wall (17) being provided with at least one primary opening (43; 43a - 43d) whereby the primary chamber (28) communicates with the or each primary cavity (20; 20a - 20d), and with at least one secondary opening (44; 44a - 44d) whereby the secondary chamber (29) communicates with the or each secondary cavity (21; 21 a - 21 d).

10. A ventilation system according to any one of claims 1-9, in which each air suction source is a fan (14, 15) mounted on said chest (16).

11. A ventilation system according to any one of claims 1-9, in which each air suction source comprises a radial blower.

12. Apparatus (1) for cooling electrical or electronic equipment, which apparatus includes a box (2) defining an enclosure (8) for receiving said equipment, the box (2) having an air inlet (10) and an air outlet (12) for creating a flow of air through said enclosure (8), said apparatus being **characterized in that** it includes a ventilation system (13) according to any one of claims 1-11.

13. Apparatus according to claim 12, in which the air outlet (12) from the box (2) is formed by a perforated top wall (4).

14. Apparatus according to claim 12 or 13, in which the cavities (20, 21) together cover the entire area of the air outlet (12).

## Patentansprüche

1. Lüftungssystem (13) für ein elektrisches oder elektronisches Gerät, das in einer Box (8) eines Gehäuses (2) eingerichtet ist, das einen Lufteintritt (10) und einen Luftaustritt (12) zur Herstellung eines Luftstroms in der Box (8) aufweist, wobei dieses Lüftungssystems (13) zumindest zwei Luftansaugquellen (14, 15), nämlich eine Primärquelle (14) und eine Sekundärquelle (15), sowie einen Kasten (16) umfasst, der zur Montage auf diesem Gehäuse (2) auf der Seite des Luftaustritts (12) bestimmt ist, **dadurch gekennzeichnet, dass** der genannte Kasten (16) zumindest zwei abgeschottete Hohlräume (20, 21) definiert, die beide zur Verbindung mit dem Luftaustritt (12) bestimmt sind, nämlich einen Primärhohlraum (20) zur Verbindung mit der Primärquelle (14) und einen Sekundärhohlraum (21) zur Verbindung mit der Sekundärquelle (15).

2. Lüftungssystem nach Anspruch 1, wobei der Kasten (16) zwei Hohlräume (20, 21) definiert, die verschachtelt und durch eine durchgehende Trennwand (22) getrennt sind.

3. Lüftungssystem nach Anspruch 2, wobei die Hohlräume (20, 21) zueinander symmetrisch sind.

4. Lüftungssystem nach Anspruch 3, wobei die Hohlräume (20, 21) zueinander eine zentrale Symmetrie aufweisen.

5. Lüftungssystem nach einem der Ansprüche 2 bis 4, wobei sich die Trennwand (22) entlang einem gekerbten Muster erstreckt, wobei jeder Hohlraum (20, 21) die Form eines Kamms aufweist.

6. Lüftungssystem nach Anspruch 1, wobei der Kasten (16) abwechselnd eine Vielzahl von Primärhohlräumen (20a bis 20d) und eine Vielzahl von Sekundärhohlräumen (21a bis 21d) definiert, wobei die Primärhohlräume (20a bis 20d) mit der Primärquelle (14) verbunden sind, wogegen die Sekundärhohlräume (21a bis 21d) mit der Sekundärquelle (15) verbunden sind.

7. Lüftungssystem nach Anspruch 6, wobei die Sekundärhohlräume (21a bis 21d) von den Primärhohlräumen (20a bis 20d) durch eine Vielzahl paralleler Zwischenwände (22a bis 22g) getrennt sind.

8. Lüftungssystem nach einem der Ansprüche 1 bis 7, wobei der Kasten (16) eine Primärkammer (28), über die der oder jeder Primärhohlraum (20, 20a bis 20d) mit der Primärquelle (14) verbunden ist, und eine Sekundärkammer (29), über die der oder jeder Sekundärhohlraum (21, 21a bis 21d) mit der Sekundärquelle (15) verbunden ist, definiert.

9. Lüftungssystem nach Anspruch 8, wobei der Kasten (16) eine Wand (17) aufweist, die jeden Hohlraum (20, 20a bis 20d; 21, 21a bis 21d) von der entsprechenden Kammer (28, 29) trennt, wobei die genannte Wand (17) mit zumindest einer Primäröffnung (43; 43a bis 43d) ausgestattet ist, über die die Primärkammer (28) mit dem oder jedem Primärhohlraum (20, 20a bis 20d) kommuniziert, und zumindest einer Sekundäröffnung (44; 44a bis 44d), über die die Sekundärkammer (29) mit dem oder jedem Sekundärhohlraum (21, 21a bis 21d) kommuniziert.

10. Lüftungssystem nach einem der Ansprüche 1 bis 9, wobei jede Luftansaugquelle ein Lüfter (14, 15) ist, der auf den genannten Kasten (16) montiert ist.

11. Lüftungssystem nach einem der Ansprüche 1 bis 9, wobei jede Luftansaugquelle eine Turbine umfasst.

12. Kühlvorrichtung (1) eines elektrischen oder elektronischen Geräts, das ein Gehäuse (2) umfasst, welches eine Box (8) zur Aufnahme des genannten Geräts definiert, wobei dieses Gehäuse (2) einen Lufteintritt (10) und einen Luftaustritt (12) aufweist, um einen Luftstrom in der genannten Box (8) herzustellen, wobei die Vorrichtung **dadurch gekennzeichnet ist, dass** es ein Lüftungssystem (13) nach einem der Ansprüche 1 bis 11 umfasst.

13. Vorrichtung nach Anspruch 12, wobei der Luftaustritt (12) des Gehäuses (2) von einer perforierten Oberwand (4) gebildet wird.

14. Vorrichtung nach Anspruch 12 oder 13, wobei die Hohlräume (20, 21) gemeinsam die gesamte Fläche des Luftaustritts (12) bedecken.
